(19) Europäisches Patentamt / European Patent Office / Office européen des brevets

(11) **EP 4 198 507 A1**

(12) **DEMANDE DE BREVET EUROPEEN**

(43) Date de publication:
**21.06.2023 Bulletin 2023/25**

(21) Numéro de dépôt: **22213369.6**

(22) Date de dépôt: **14.12.2022**

(51) Classification Internationale des Brevets (IPC):
**G01N 29/12** (2006.01)   **G01N 29/48** (2006.01)
**G01N 29/50** (2006.01)   **H04B 5/00** (2006.01)

(52) Classification Coopérative des Brevets (CPC):
**G01N 29/12; G01N 29/48; G01N 29/50;**
G01N 2291/02863; G01N 2291/2697; H04B 5/0043

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(30) Priorité: **17.12.2021 FR 2113820**

(71) Demandeur: **Commissariat à l'énergie atomique et aux énergies alternatives**
**75015 Paris (FR)**

(72) Inventeurs:
• **DESPESSE, Ghislain**
  **38054 GRENOBLE Cedex 09 (FR)**

• **FREYCHET, Olivier**
  **38054 GRENOBLE Cedex 09 (FR)**
• **GARRAUD, Nicolas**
  **38054 GRENOBLE Cedex 09 (FR)**
• **MARIANNE, Julien**
  **38600 FONTAINE (FR)**
• **BOISSEAU, Sébastien**
  **38054 GRENOBLE Cedex 09 (FR)**
• **CAROFF, Tristan**
  **38054 GRENOBLE Cedex 09 (FR)**

(74) Mandataire: **Atout PI Laplace**
**Immeuble "Visium"**
**22, avenue Aristide Briand**
**94117 Arcueil Cedex (FR)**

(54) **PROCEDE ET SYSTEME DE DETERMINATION DE L'ETAT D'UN CAPTEUR A TRAVERS UN SUPPORT**

(57) L'invention se rapporte à un procédé de détermination de l'état d'au moins un capteur (1), ledit procédé utilisant un premier transducteur électromécanique (2) et un second transducteur électromécanique (3) couplés à un support (4), et un circuit électrique non-linéaire (5) connecté entre le second transducteur électromécanique (3) et le capteur (1), le procédé comprenant les étapes consistant à:
- appliquer un signal électrique (Vin) à une première amplitude aux bornes du premier transducteur électromécanique (2), et déterminer un premier ensemble de valeurs d'un paramètre caractéristique de l'impédance électrique du premier transducteur électromécanique (2) en réponse à l'application dudit signal électrique ;
- appliquer ledit signal électrique à une deuxième amplitude aux bornes du premier transducteur électromécanique (2), et déterminer un deuxième ensemble de valeurs du paramètre caractéristique de l'impédance ;
- mesurer un écart entre le premier ensemble de valeurs et le deuxième ensemble de valeurs ;
- déterminer un état du capteur (1) en fonction de l'écart entre le premier ensemble de valeurs et le deuxième ensemble de valeurs.

FIG.1

## Description

### Domaine technique

L'invention concerne de manière générale les systèmes de mesure, et en particulier un procédé et un système de détermination de l'état d'un capteur à travers un support.

Dans certains domaines, des systèmes de mesure sont utilisés pour effectuer des mesures à travers un support conducteur ou une paroi conductrice, telle qu'une canalisation, dans un milieu difficile d'accès, dangereux, corrosif ou hostile, et de rendre cette donnée accessible. De tels systèmes de mesure utilisent classiquement un capteur.

Cependant, le milieu où se trouve le capteur peut être difficile d'accès (par exemple l'intérieur d'une coque de bateau, d'un bloc de béton, d'un bloc de métal, de canalisations, de cuves). Il peut donc être, dans certains cas, difficile d'utiliser des capteurs actifs alimentés par des piles ou par des batteries, qui nécessitent d'être changés ou chargés régulièrement.

Il est connu d'utiliser des dispositifs passifs de radio-identification (ou RFID pour « Radio Frequency Identification »), dans lesquels des mesures issues d'un capteur sont mémorisées et récupérées à distance en utilisant des marqueurs appelés « radio-étiquettes ». Toutefois, la technologie RFID ne fonctionne pas lorsque le support séparant le système d'interrogation du capteur et le capteur lui-même est conducteur.

Par ailleurs, les dimensions des antennes radio peuvent rendre délicate leur intégration dans le milieu. En effet, la longueur d'onde d'une onde acoustique est drastiquement plus courte qu'une onde radio (facteur <1/1000), ce qui permet de réaliser des systèmes d'interrogation beaucoup plus compacts. Les dimensions des systèmes d'interrogation sont typiquement de l'ordre d'une longueur d'onde.

Dans les systèmes d'interrogation fonctionnant avec des ondes radio, le milieu de transmission (l'air, le vide) peut être considéré homogène et quasi infini, et il n'interagit que très peu avec le signal.

En revanche, dans les systèmes d'interrogation fonctionnant avec des ondes acoustiques, le milieu interagit fortement avec le signal. En effet, la vitesse de propagation dépend des matériaux, le milieu n'étant pas infini, et il peut y avoir de nombreux échos non maitrisés.

Une solution connue, décrite dans le document US 5 594 705, divulgue un transformateur acoustique pour coupler de l'énergie à travers un support (par exemple une coque de bateau). Le transformateur acoustique comprend un premier transducteur couplé au support, un deuxième transducteur couplé au support, à l'opposé du premier transducteur, un générateur couplé au premier transducteur pour appliquer un signal alternatif, et des moyens pour faire varier la charge du côté du deuxième transducteur, afin d'induire des variations dans le signal alternatif aux bornes du premier transducteur.

Une telle solution utilise la communication en modulation de charge. En effet, le moyen pour faire varier la charge du côté du deuxième transducteur doit être alimenté par un circuit électronique, qui interprète alors une information capteur et la traduit en une modulation de charge. Un tel dispositif ne contient pas de batterie mais nécessite un circuit actif (modulateur) qui interroge un capteur et transforme la donnée mesurée en un signal de modulation.

D'autres solutions passives existent dans le domaine RF. Les propriétés du capteur sont alors directement modifiées par le paramètre physique à mesurer (antenne capteur).

Par exemple, il est connu qu'une résistance variable peut être insérée dans le capteur pour obtenir une thermistance dont la résistance varie avec la température, ou une jauge de contrainte dont la résistance varie en fonction d'une déformation/contrainte.

Il est également connu d'insérer une capacité variable dans le capteur pour obtenir un accéléromètre capacitif (capacité qui dépend de l'accélération), une capacité avec des propriétés du diélectrique qui dépendent de la température/contrainte, ou encore un capteur capacitif (capteur de proximité, mesure de distance, mesure de position, mesure de présence, mesure de remplissage d'un liquide).

Un résonateur peut également être inséré dans le capteur pour détecter un changement de fréquence de résonance avec la température ou la contrainte mécanique, qui changent la réponse en fréquence de l'antenne. Un tel fonctionnement est utilisé classiquement dans les capteurs à ondes acoustiques de surface (capteurs SAW pour Surface Acoustic Wave).

Ce type d'antenne capteur fournit sensiblement la même réponse vue par l'interrogateur RF, quel que soit l'environnement, à partir du moment où cet environnement n'est pas conducteur électrique.

Cependant, dans le domaine des interrogateurs acoustiques, il n'est pas possible de faire une telle hypothèse. En effet, l'onde acoustique ne se propage pas dans le vide et dans l'air car les niveaux d'énergie transmissible sont faibles au regard de ce qui peut être transmis au travers de solides ou de liquides.

De ce fait, la propagation acoustique est très dépendante des matériaux physiques en présence. Les hypothèses d'un milieu connu, isotrope et quasi-infini ne sont plus valables. La déformation du signal liée à ce canal ne peut plus être prédéterminée de manière générique, et il est nécessaire de modéliser chaque situation pour en déduire l'effet du canal dans chacun des cas et ainsi remonter à un changement propre d'une des propriétés du capteur acoustique.

**EP 4 198 507 A1**

Il existe ainsi un besoin pour des procédés et des systèmes détermination de l'état d'un capteur par un mode d'interrogation acoustique passif, qui ne nécessite pas de caractériser le canal de propagation.

**Résumé de l'invention**

L'invention vise à remédier aux inconvénients précités, en proposant un procédé flexible et simple d'utilisation.

Un objet de l'invention est donc un procédé de détermination de l'état d'au moins un capteur, ledit procédé utilisant un premier transducteur électromécanique et un second transducteur électromécanique mécaniquement couplés à un support, et un circuit électrique non-linéaire exclusivement analogique électriquement connecté entre le second transducteur électromécanique et le capteur, le procédé comprenant les étapes consistant à:

- appliquer un signal électrique à une première amplitude aux bornes du premier transducteur électromécanique, et déterminer un premier ensemble de valeurs d'un paramètre caractéristique de l'impédance électrique du premier transducteur électromécanique en réponse à l'application dudit signal électrique ;
- appliquer ledit signal électrique à une deuxième amplitude aux bornes du premier transducteur électromécanique, et déterminer un deuxième ensemble de valeurs du paramètre caractéristique de l'impédance ;
- mesurer un écart entre le premier ensemble de valeurs et le deuxième ensemble de valeurs ;
- déterminer un état du capteur en fonction de l'écart entre le premier ensemble de valeurs et le deuxième ensemble de valeurs.

Avantageusement, le capteur comprend un composant électronique à valeur variable, le procédé comprenant les étapes consistant à :

- déterminer une première valeur d'un paramètre caractéristique de l'impédance électrique du premier transducteur électromécanique, à la première amplitude,
- déterminer une deuxième valeur d'un paramètre caractéristique de l'impédance électrique du premier transducteur électromécanique, à la deuxième amplitude, la première valeur et la deuxième valeur étant telles que l'écart soit non nul,
- appliquer le signal électrique à une troisième amplitude, la troisième amplitude étant comprise entre la première amplitude et la deuxième amplitude, et déterminer une troisième valeur d'un paramètre caractéristique de l'impédance électrique du premier transducteur électromécanique, à la troisième amplitude,
- déterminer la valeur variable du composant électronique à valeur variable en fonction de la première valeur, de la deuxième valeur, et de la troisième valeur.

Avantageusement, la mesure d'un écart entre le premier ensemble de valeurs et le deuxième ensemble de valeurs est effectuée dans une plage de fréquences prédéfinie, et comprend, à l'intérieur de la plage de fréquences, une mesure d'un écart de fréquences entre les passages par une valeur de module d'impédance prédéfinie ou par une valeur d'argument d'impédance prédéfini du premier ensemble de valeurs et du deuxième ensemble de valeurs.

En variante, la mesure d'un écart entre le premier ensemble de valeurs et le deuxième ensemble de valeurs est effectuée dans une plage de fréquences prédéfinie, et comprend, à l'intérieur de la plage de fréquences, une mesure d'un écart de fréquences entre la valeur extrêmale du premier ensemble de valeurs et la valeur extrêmale du deuxième ensemble de valeurs.

En variante, dans lequel la mesure d'un écart entre le premier ensemble de valeurs et le deuxième ensemble de valeurs est effectuée dans une plage de fréquences prédéfinie, et comprend, à l'intérieur de la plage de fréquences, une mesure de l'écart de phase entre le premier ensemble de valeurs et le deuxième ensemble de valeurs à des fréquences correspondant à une valeur prédéfinie ou un extremum du module du premier ensemble de valeurs et à une valeur prédéfinie ou un extremum du module du deuxième ensemble de valeurs.

En variante, la mesure d'un écart entre le premier ensemble de valeurs et le deuxième ensemble de valeurs est effectuée dans une plage de fréquence prédéfinie, et comprend, à l'intérieur de la plage de fréquences, une mesure de l'écart de module entre le premier ensemble de valeurs et le deuxième ensemble de valeurs à des fréquences correspondant à une valeur prédéfinie ou un extremum de phase du premier ensemble de valeurs et à une valeur prédéfinie ou un extremum de phase du deuxième ensemble de valeurs.

L'invention se rapporte également à un système de détermination de l'état d'au moins un capteur, le système comprenant un premier transducteur électromécanique et un second transducteur électromécanique mécaniquement couplés à un support, et un circuit électrique non-linéaire exclusivement analogique électriquement connecté entre le second transducteur électromécanique et le capteur, le système comprenant une unité de détermination d'état de capteur, l'unité de détermination d'état de capteur étant configurée pour :

- appliquer un signal électrique à une première amplitude aux bornes du premier transducteur électromécanique, et déterminer un premier ensemble de valeurs d'un paramètre caractéristique de l'impédance électrique du premier transducteur électromécanique en réponse à l'application dudit signal électrique ;
- appliquer ledit signal électrique à une deuxième amplitude aux bornes du premier transducteur électromécanique, et déterminer un deuxième ensemble de valeurs du paramètre caractéristique de l'impédance ;
- mesurer un écart entre le premier ensemble de valeurs et le deuxième ensemble de valeurs ;
- déterminer un état du capteur en fonction de l'écart entre le premier ensemble de valeurs et le deuxième ensemble de valeurs.

Avantageusement, le circuit électrique non-linéaire comprend deux diodes en parallèle et polarisées en inverse l'une par rapport à l'autre, les diodes étant configurées pour être connectées en parallèle avec le capteur.

En variante, le circuit électrique non-linéaire comprend deux diodes Zener montées en tête bêche en série, les diodes Zener étant configurées pour être connectées en série avec le capteur.

En variante, le circuit électrique non-linéaire comprend une première branche et une deuxième branche connectées en parallèle, la première branche comprenant deux diodes Zener connectées en tête bêche en série, la deuxième branche comprenant deux diodes connectées en parallèle, polarisées en inverse l'une par rapport à l'autre, et configurées pour être connectées en série avec le capteur.

En variante, le circuit électrique non-linéaire comprend un premier limiteur de courant et un second limiteur de courant connectés en série, le premier limiteur de courant étant par ailleurs configuré pour être connecté en parallèle au capteur, la valeur du courant de court-circuit du premier limiteur de courant étant inférieure à la valeur du courant de court-circuit du second limiteur de courant.

En variante, le circuit électrique non-linéaire comprend une première branche, une deuxième branche et une troisième branche connectées en parallèle, la première branche comprenant deux diodes Zener connectées en tête bêche en série, la deuxième branche comprenant deux diodes connectées en parallèle et polarisées en inverse l'une par rapport à l'autre, et configurées pour être connectées en série avec un premier capteur, la troisième branche comprenant deux diodes Zener montées en tête bêche en série, les diodes Zener de la troisième branche étant configurées pour être connectées en série avec un deuxième capteur.

En variante, le circuit électrique non-linéaire comprend une première branche et une deuxième branche, la première branche comprenant deux diodes connectées en parallèle et polarisées en inverse l'une par apport à l'autre, et configurées pour être connectées en parallèle à un premier capteur, la deuxième branche comprenant deux diodes connectées en parallèles et polarisées en inverse l'une par apport à l'autre, la première et la deuxième branche étant configurées pour être connectées en série à un deuxième capteur.

En variante, le circuit électrique non-linéaire comprend un pont redresseur connecté aux bornes du second transducteur électromécanique, et un transistor commandé par la tension aux bornes du capteur, l'unité de détermination d'état de capteur étant configurée pour déterminer un état du capteur en fonction de la tension de mise en conduction du transistor.

Avantageusement, le premier transducteur électromécanique et le second transducteur électromécanique comprennent chacun un composant piézoélectrique.

## Description des figures

D'autres caractéristiques, détails et avantages de l'invention ressortiront à la lecture de la description faite en référence aux dessins annexés donnés à titre d'exemple.

La figure 1 est un schéma représentant un système selon l'invention.

La figure 2 est un organigramme représentant un procédé selon l'invention.

La figure 3 est un graphe représentant une évolution du module et de l'argument de l'impédance vue par le premier transducteur, pour deux amplitudes du signal électrique.

La figure 4 illustre un premier mode de réalisation du système selon l'invention.

La figure 5 est un graphe représentant une évolution de l'argument de l'impédance vue par le premier transducteur, pour deux amplitudes du signal électrique, avec le système selon le premier mode de réalisation.

Les figures 6, 7 et 9 à 12 illustrent d'autres modes de réalisation du système selon l'invention.

La figure 8 est un graphe représentant l'évolution de l'impédance vue par le premier transducteur, pour différentes valeurs d'amplitude du signal électrique.

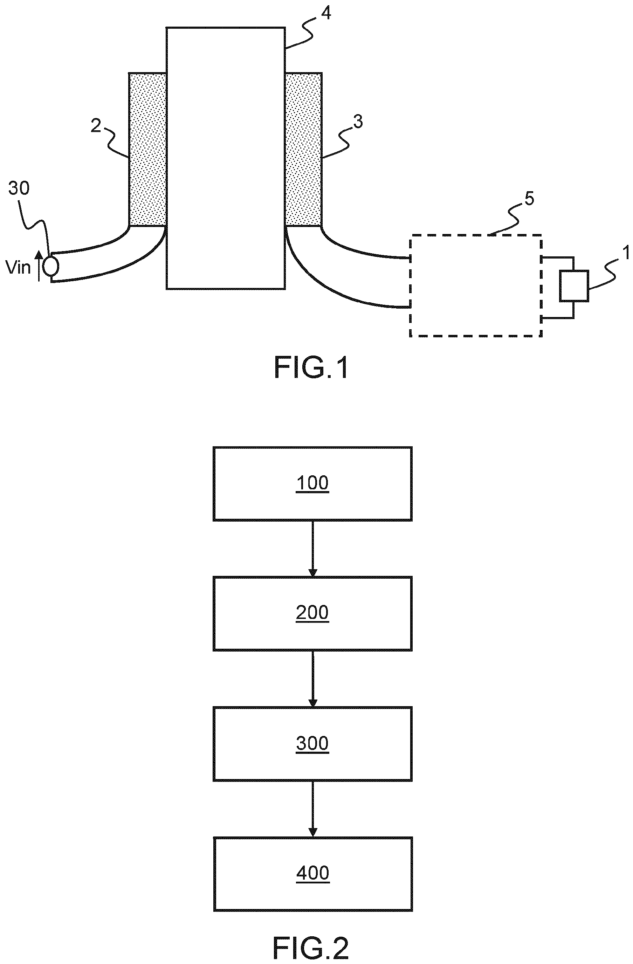

La figure 1 illustre la configuration dans laquelle le procédé peut s'appliquer. Un premier transducteur électromécanique 2 et un second transducteur électromécanique 3 sont disposés de part et d'autre d'un support 4. D'autres configurations sont envisageables, par exemple le second transducteur électromécanique 3 est disposé sur le même côté du support que le premier transducteur électromécanique 2, mais à un endroit inaccessible. Le support est une pièce mécanique rigide, dans laquelle peut se propager une onde vibratoire générée par un des transducteurs électromécaniques.

Le premier transducteur électromécanique 2 et le second transducteur électromécanique 3 sont couplés mécaniquement au support 4, c'est-à-dire en contact physique avec le support 4, de façon à ce que la propagation de l'onde vibratoire entre les transducteurs soit optimale. Ainsi, il est nécessaire qu'au moins un mode acoustique puisse se propager entre le premier transducteur électromécanique 2 et le second transducteur électromécanique 3. Les transducteurs peuvent par exemple être fixés par collage au support 4, ou par exemple via des pattes de fixation ou maintenus en contact par la force magnétique d'un aimant ou encore, du côté du premier transducteur électromécanique 2, maintenus en contact par une pression exercée par l'utilisateur.

Sur la figure 1, le support a des dimensions proches de celles des transducteurs électromécaniques, mais l'invention peut s'appliquer à des supports de longueurs variables, allant par exemple d'une petite pièce mécanique de type pièce de moteur, à une très grande pièce telle qu'une canalisation. De même, il n'est pas nécessaire que les transducteurs électromécaniques soient du même type. Dans le cas où les deux transducteurs électromécaniques sont des transducteurs piézoélectriques, leurs dimensions peuvent être identiques. En variante, un des transducteurs électromécaniques peut être un transducteur piézoélectrique, et l'autre transducteur électromécanique peut être de nature différente (par exemple une bobine et un aimant).

Dans le cas d'une pièce de type canalisation, il est entendu que le second transducteur électromécanique 3 est disposé à l'intérieur de la canalisation, à un endroit difficile d'accès. Le second transducteur électromécanique 3 peut aussi être disposé à l'extérieur, à un endroit éloigné difficile d'accès (intérieur d'un forage, dans une cuve contenant un liquide, ou encore dans une conduite forcée qui peut être sur une paroi raide et difficile d'accès, par exemple en montagne). Dans ce cas, il peut être intéressant de pouvoir interroger des capteurs éloignés à partir de points où la conduite est accessible facilement.).

Le premier transducteur électromécanique 2 et le second transducteur électromécanique 3 sont disposés de préférence de façon à se faire face au travers du support 4, afin d'optimiser la transmission de puissance entre les deux transducteurs électromécaniques.

L'invention s'applique particulièrement à des supports 4 métalliques, pour lesquelles l'interrogation par RFID n'est pas fiable. Toutefois, l'invention peut être étendue à tout type de support 4, sans limitation liée au matériau.

Les transducteurs électromécaniques sont conçus pour recevoir de l'énergie d'un système électrique et fournir de l'énergie à un système mécanique, ou réciproquement. Les transducteurs électromécaniques peuvent avantageusement être des transducteurs électroacoustiques, et plus particulièrement des transducteurs piézoélectriques. Les transducteurs piézoélectriques comprennent un matériau électro-actif qui induit une tension lorsqu'une pression ou une contrainte lui est appliquée, et réciproquement. D'autres transducteurs électromécaniques peuvent être envisagés, par exemple les transducteurs électrostatiques à électret, ou les transducteurs électromagnétiques.

Un circuit non linéaire exclusivement analogique est connecté entre le second transducteur électromécanique 3 et le capteur 1. Par circuit non linéaire, on entend une charge dont le comportement est fondamentalement différent suivant la valeur d'un paramètre (par exemple l'amplitude de la tension ou du courant) appliqué aux bornes du circuit. Par « exclusivement analogique », on entend un circuit passif, ou un circuit comprenant des transistors en régime linéaire (le caractère non linéaire du circuit est différent du régime linéaire d'un transistor). Ainsi, le circuit non linéaire ne comprend aucun calculateur, et n'est pas commandé par un circuit de contrôle numérique. De par sa nature exclusivement analogique, le circuit non linéaire n'effectue aucune analyse ou de mesure de l'état du capteur, et n'effectue aucune modulation en fonction de l'état du capteur.

L'idée à la base de l'invention est de pouvoir mesurer l'état d'un capteur à distance via une mesure différentielle d'impédance électrique d'un transducteur électromécanique, à partir d'au moins deux mesures d'impédance à deux amplitudes différentes.

Il est rappelé que l'impédance électrique mesure l'opposition d'un circuit électrique au passage d'un courant alternatif sinusoïdal.

Une unité de détermination d'état de capteur 30, comprenant une source de tension, ou une source de courant, est connectée électriquement au premier transducteur électromécanique 2, de façon à imposer une respectivement une tension sinusoïdale à une amplitude maximale prédéfinie, ou un courant sinusoïdal à une amplitude maximale prédéfinie, aux autres éléments du système.

La mesure de l'impédance peut être effectuée par un dispositif de mesure d'impédance, également appelé impédancemètre, qui peut être intégré à l'unité 30 de détermination d'état de capteur. Selon une variante, la mesure de l'impédance peut être effectuée dans un dispositif de calcul distinct de la source de tension ou de courant, par exemple dans un ordinateur.

L'impédance électrique du premier transducteur électromécanique 2 correspond donc à celle qui est « vue » par l'unité 30 de détermination.

Pour les différents modes de réalisation décrits ci-après, il est possible d'imposer une tension Vin à l'aide d'une source de tension, et de mesurer le courant $I_{in}$ afin de déterminer l'impédance. Il est également possible d'imposer une intensité $I_{in}$ à l'aide d'une source de courant, et de mesurer la tension Vin afin de déterminer l'impédance. La notion d'amplitude de la mesure peut s'appliquer aussi bien à $I_{in}$ qu'à Vin.

Le procédé comprend, dans une première étape 100 (figure 2), d'appliquer un signal électrique à une première amplitude aux bornes du premier transducteur électromécanique 2, et de déterminer un premier ensemble de valeurs d'un paramètre caractéristique de l'impédance du premier transducteur électromécanique 2 en réponse à l'application dudit signal électrique.

La bande de fréquence du signal électrique est de préférence située autour de la fréquence d'un mode de résonance du premier transducteur électromécanique 2 et/ou d'un mode de résonance du second transducteur électromécanique 3.

Dans une deuxième étape 200 (figure 2), le signal électrique est appliqué à une deuxième amplitude, et un deuxième ensemble de valeurs du paramètre caractéristique de l'impédance est déterminé.

L'information liée à l'état du capteur 1 est codée dans la non linéarité de l'impédance du second transducteur électromécanique 3 associé au circuit électrique non-linéaire 5 en fonction de l'amplitude du signal de mesure imposée par la source de tension ou de courant.

C'est le comportement du second transducteur électromécanique 3, mis en mouvement via le support 4, qui en retour de cette mise en mouvement, présente une contre-réaction mécanique non linéaire avec l'amplitude.

Le canal de propagation est considéré comme linéaire avec l'amplitude du signal émis, contrairement au second transducteur électromécanique 3 associé au circuit électrique non-linéaire 5 et au capteur 1, ce qui permet de discriminer les propriétés non linéaires du second transducteur électromécanique 3 associé au circuit électrique non-linéaire 5 et au capteur 1 vis-à-vis du canal.

Dans une troisième étape 300 du procédé (figure 2), un écart entre le premier ensemble de valeurs et le deuxième ensemble de valeurs est mesuré, selon un des critères de proximité définis ci-après. L'écart correspond à une différence entre deux ensembles de valeurs, selon un critère prédéfini.

Ainsi, en sélectionnant de façon appropriée la première et la deuxième amplitude, l'état du capteur 1 peut être déterminé en fonction de l'écart entre le premier ensemble de valeurs et le deuxième ensemble de valeurs (quatrième étape 400).

Le procédé peut être répété de façon périodique, afin d'évaluer régulièrement l'état du capteur 1. Il peut, en alternative ou en complément, être implémenté ponctuellement, par exemple en cas de mesure aberrante du capteur 1.

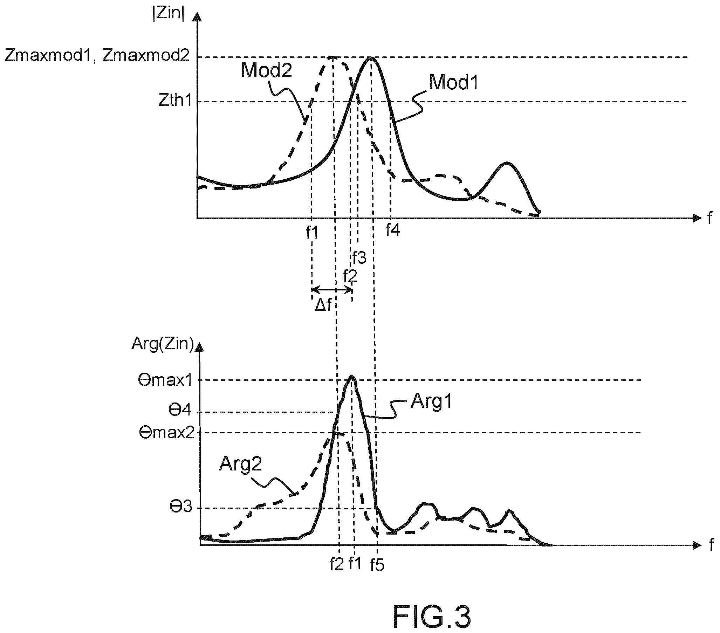

La figure 3 illustre deux mesures permettant de caractériser l'impédance, à savoir le module (partie supérieure de la figure 3), et l'argument (partie inférieure de la figure 3). Le module correspond au rapport entre l'amplitude de la tension et l'amplitude du courant, et l'argument correspond à la différence entre la valeur de phase de la tension et la valeur de phase du courant.

La courbe Mod1 correspond à une pluralité de mesures du module de l'impédance vue par le premier transducteur électromécanique 2, pour différentes fréquences du signal, à une première amplitude. Pour un signal sinusoïdal, ou plus généralement pour un signal alternatif, l'amplitude correspond à la valeur de crête du signal, c'est-à-dire la valeur maximale. La courbe Mod2 correspond à une pluralité de mesures du module de l'impédance vue par le premier transducteur électromécanique 2, pour différentes fréquences du signal, à une deuxième amplitude, différente de la première amplitude.

Il est possible, par exemple, d'effectuer les mesures pour un ensemble fini de fréquences, et d'effectuer ensuite une opération d'interpolation, afin d'obtenir un ensemble continu de valeurs, sur une plage de fréquences prédéterminée.

La plage de fréquence de mesure est prédéfinie, et peut être par exemple déterminée en fonction des propriétés du premier transducteur électromécanique 2 et/ou du second transducteur électromécanique 3.

La courbe Arg1 correspond à une pluralité de mesures de l'argument de l'impédance vue par le premier transducteur électromécanique 2, pour différentes fréquences du signal, à la première amplitude. La courbe Arg2 correspond à une pluralité de mesures de l'argument de l'impédance vue par le premier transducteur électromécanique 2, pour différentes fréquences du signal, à la deuxième amplitude.

Il n'est pas nécessaire, pour mettre en œuvre le procédé selon l'invention, de mesurer le module et l'argument. L'une des deux mesures peut suffire ; cela dépend de la définition de l'écart, comme défini ci-après.

Selon un premier mode de réalisation, la mesure de l'écart entre le premier ensemble de valeurs et le deuxième ensemble de valeurs comprend la mesure d'un écart de fréquences entre les passages par une valeur de module d'impédance prédéfinie ou par une valeur d'argument d'impédance prédéfinie du premier ensemble de valeurs et du deuxième ensemble de valeurs.

La partie supérieure de la figure 3 illustre le mode de réalisation précité, avec une valeur de module d'impédance prédéfinie Zth1. L'ensemble de valeurs Mod1 à la première amplitude atteint la valeur Zth1 pour les fréquences f2 et f4. L'ensemble de valeurs Mod2 à la deuxième amplitude atteint la valeur Zth1 pour les fréquences f1 et f3.

Dans un mode de réalisation, seules les fréquences correspondant au premier dépassement du seuil Zth1 sont considérées. Ainsi, selon ce mode de réalisation, l'écart entre le premier ensemble de valeurs Mod1 et le deuxième ensemble de valeurs Mod2 correspond à la différence Δf=f2-f1.

Selon un autre mode de réalisation de calcul de l'écart entre les ensembles de valeurs, l'écart peut être défini, à l'intérieur d'une plage de fréquences prédéfini, par l'écart de fréquences entre la valeur extrêmale du premier ensemble de valeurs et la valeur extrêmale du deuxième ensemble de valeurs.

La valeur extrêmale correspond de préférence au maximum de chaque ensemble de valeurs. Sur la partie inférieure de la figure 3, le premier ensemble de valeurs de l'argument Arg1 à la première amplitude a une valeur maximale $\theta max1$, à une fréquence f1, et le deuxième ensemble de valeurs de l'argument Arg2 à la deuxième amplitude a une valeur maximale $\theta max2$, à une fréquence f2. Selon ce mode de réalisation, l'écart correspond à la différence Δf=f1-f2.

Selon un autre mode de réalisation illustré par la partie inférieure de la figure 3, l'écart peut être calculé en mesurant, dans la plage de fréquences prédéfinie, l'écart de module ou d'argument entre l'extremum du premier ensemble de valeurs et l'extremum du deuxième ensemble de valeurs. L'extremum correspond de préférence à la valeur maximale.

Sur l'exemple de la figure 3 (partie inférieure), l'écart peut être obtenu par le calcul $\Delta\theta = \theta max1 - \theta max2$.

Selon un autre mode de réalisation, l'écart correspond à une différence d'argument entre le premier ensemble de valeurs et le deuxième ensemble de valeurs à des fréquences correspondant à un extremum (ou à une valeur prédéfinie) du module du premier ensemble de valeurs et à l'extremum (ou à une valeur prédéfinie) du module du deuxième ensemble de valeurs. L'extremum correspond de préférence au maximum de chaque ensemble de valeurs.

Par exemple, sur la partie supérieure de la figure 3, le premier ensemble de valeurs Mod1 du module à une première amplitude, et le deuxième ensemble de valeurs Mod2 du module à une deuxième amplitude, ont chacun une valeur maximale, respectivement Zmaxmod1 et Zmaxmod2, qui sont égales sur la figure 3.

La valeur Zmaxmod1 est atteinte à la fréquence f5, et la valeur Zmaxmod2 est atteinte à la fréquence f2. En supposant que le graphique de la partie supérieure et celui de la partie inférieure puissent être alignés, la valeur de l'argument du premier ensemble de valeur Arg1 à la fréquence f5 vaut $\theta3$, et la valeur de l'argument du deuxième ensemble de valeur Arg2 à la fréquence f2 vaut $\theta4$. Selon ce mode de réalisation, l'écart correspond à la différence $\Delta\theta = \theta4 - \theta3$.

Le même principe de mesure peut être appliqué réciproquement en calculant une mesure de l'écart de module entre le premier ensemble de valeurs et le deuxième ensemble de valeurs à des fréquences correspondant à un extremum d'argument (en particulier le maximum) du premier ensemble de valeurs (ou à une valeur prédéfinie) et à un extremum d'argument (en particulier le maximum) du deuxième ensemble de valeurs (ou à une valeur prédéfinie).

Selon un autre mode de réalisation, l'écart est calculé à partir d'une inter-corrélation entre les deux ensembles de mesures.

Le calcul de l'écart entre l'ensemble de valeurs à la première amplitude et l'ensemble de valeurs à la deuxième amplitude, selon l'un des modes de réalisation précités, permet de déterminer si le paramètre caractéristique de l'impédance (module ou argument) du premier transducteur électromécanique 2, vue par l'unité 30 de détermination d'état de capteur, en réponse à l'application dudit signal électrique, varie, ou au contraire reste sensiblement constant, selon que le signal soit appliqué avec la première ou avec la deuxième amplitude.

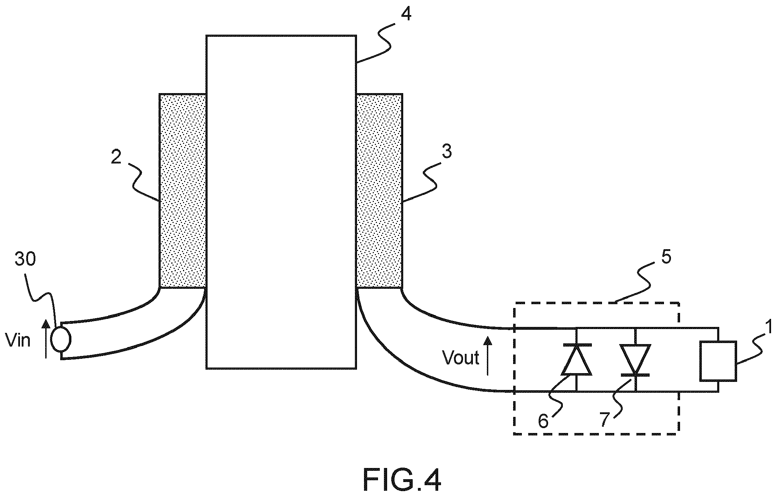

La figure 4 illustre un mode de réalisation du système de détermination de l'état d'au moins un capteur selon l'invention. Le circuit électrique non-linéaire 5 comprend une première diode 6 et une deuxième diode 7 connectées en parallèle, et polarisées en inverse l'une par rapport à l'autre. Les diodes sont connectées en parallèle avec le capteur 1.

Pour un capteur 1 de type « tout-ou-rien », tel qu'un capteur de butée ou de fin de course, le système permet de déterminer si le contact du capteur est ouvert (circuit ouvert) ou fermé (court-circuit).

L'information relative à l'état ouvert ou fermé peut être déterminée en appliquant le signal électrique à deux amplitudes différentes, comme décrit précédemment.

Si le capteur 1 est en court-circuit, l'impédance vue par le premier transducteur électromécanique 2 est identique, ou sensiblement identique, indépendamment de l'amplitude du signal électrique. Ainsi, s'il est déterminé que l'écart entre le premier ensemble de valeurs et le deuxième ensemble de valeurs est nul, il peut être conclu que le capteur 1 est en court-circuit.

Une marge de tolérance peut être appliquée à la détermination de l'écart entre le premier ensemble de valeurs et le deuxième ensemble de valeurs. La marge de tolérance peut être par exemple une valeur prédéterminée, ou une fraction de la plage de fréquence prédéfinie, ou de l'écart entre les valeurs maximales et minimales du module ou de l'argument de l'impédance.

Si le capteur 1 est en circuit ouvert, l'impédance électrique vue par le deuxième transducteur 3 est très grande lorsque la tension Vout (tension aux bornes du circuit non linéaire 5) est inférieure à la tension de seuil des diodes (typiquement inférieure à 0,6 V, cette valeur dépendant de la technologie de la diode). L'impédance est faible lorsque la tension Vout tend à être très supérieure à la tension de seuil des diodes, c'est-à-dire que l'amplitude de la tension à vide serait beaucoup plus élevée que l'amplitude de la tension effective en présence des diodes.

Cette variation d'impédance électrique, connectée au niveau du second transducteur électromécanique 3, avec l'amplitude crée une différence mesurable entre l'impédance mesurée à la première amplitude et l'impédance mesurée à la deuxième amplitude au niveau de l'impédance électrique du premier transducteur électromécanique 2.

Ce mode de réalisation permet, de façon avantageuse, de détecter une ouverture du capteur 1, alors que le capteur est dans un état naturellement fermé. L'apparition d'un écart entre le premier ensemble de valeurs et le deuxième ensemble de valeurs caractérise en effet l'ouverture du capteur 1.

Les amplitudes sont prédéterminées, de façon à ce que, pour une des amplitudes, la tension Vout à vide soit inférieure à la tension de seuil des diodes, et que pour l'autre amplitude, la tension Vout à vide soit supérieure à la tension de seuil des diodes.

Il est par exemple possible de définir les amplitudes à appliquer au signal électrique au moyen de mesures empiriques réalisées lors d'une phase de calibration du procédé, ou au moyen de simulation du canal de propagation.

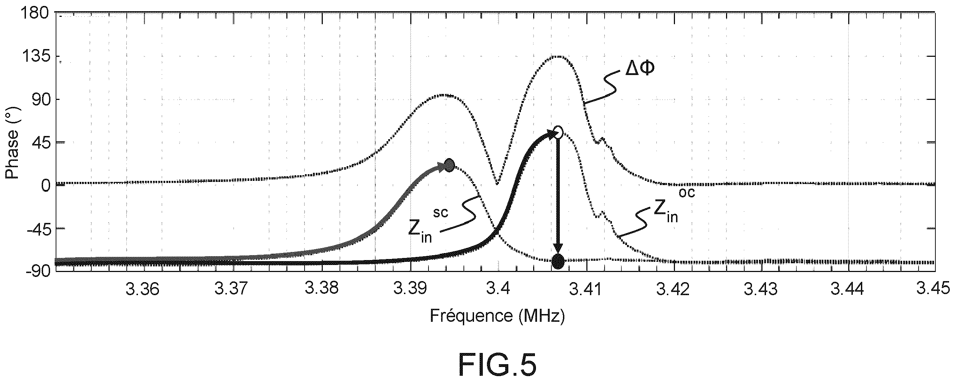

La figure 5 illustre le principe de détection de l'état ouvert ou fermé d'un capteur, avec le système selon le mode de réalisation de la figure 4.

Dans le cas où le capteur 1 est en court-circuit, l'ensemble de valeurs de l'argument de l'impédance correspond à la courbe $Z_{in}^{sc}$. L'ensemble de valeurs est identique, quelle que soit l'amplitude du signal électrique.

Dans le cas où le capteur 1 est en circuit ouvert, et si le signal électrique a une forte amplitude (telle que Vout à vide >>Vthd, où Vthd correspond à la tension de seuil des diodes 6 et 7), l'amplitude de Vout est écrêtée par la diode 7 sur l'alternance positive et la diode 6 sur l'alternance négative ; ainsi, l'ensemble de valeurs correspond sensiblement à l'ensemble de valeurs de l'argument de l'impédance $Z_{in}^{sc}$ lorsque le capteur 1 est en court-circuit.

Dans le cas où le capteur 1 est en circuit ouvert, et si le signal électrique a une faible amplitude (telle que Vout à vide <Vthd), les diodes 6 et 7 sont bloquées. La courbe $Z_{in}^{oc}$ représente l'ensemble de valeurs correspondant, qui est distinct de l'ensemble de valeurs de l'argument de l'impédance $Z_{in}^{sc}$ lorsque le capteur 1 est en court-circuit.

La courbe $\Delta\Phi$ correspond à la différence entre les courbes de phase de $Z_{in}^{oc}$ et de $Z_{in}^{sc}$. Le maximum de la courbe $\Delta\Phi$ est situé à une fréquence du signal électrique égale à 3,406 MHz. La différence entre les deux ensembles de valeurs à cette fréquence vaut environ 135°.

Le fait d'avoir une telle différence entre les deux ensembles de valeurs permet de déterminer l'état du capteur.

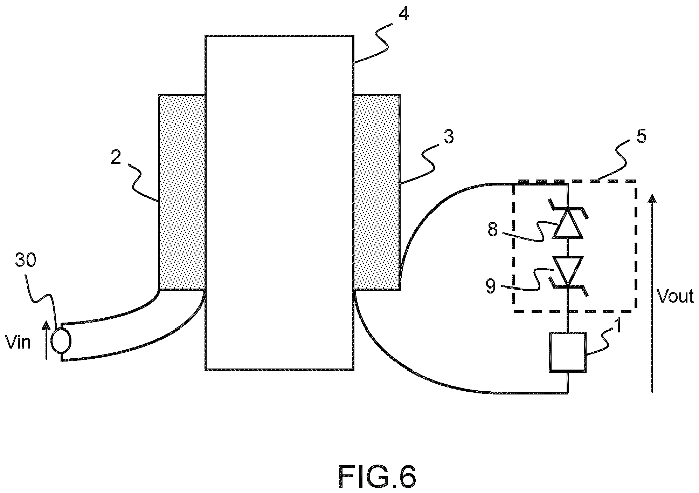

Selon un autre mode de réalisation du système, illustré par la figure 6, le circuit électrique non-linéaire 5 comprend deux diodes Zener (8, 9) montées en tête bêche en série, c'est-à-dire dont les anodes sont directement connectées entre elles. Les diodes Zener (8, 9) sont également connectées en série avec le capteur 1. Il est possible de choisir le type de diode Zener en fonction des tensions Zener souhaitées.

Si le capteur 1 est en circuit ouvert, il n'y a pas ou peu de variation d'impédance en fonction de l'amplitude du signal électrique. Si le capteur 1 est en court-circuit, avec un signal électrique de faible amplitude, l'impédance électrique vue par le premier transducteur électromécanique 2 est différente de celle vue avec un signal électrique de forte amplitude.

La faible amplitude et la forte amplitude sont prédéterminées, en fonction des tensions Zener de la diode 8 et de la diode 9, et de leur tension de seuil.

Ce mode de réalisation permet, de façon avantageuse, de détecter une fermeture du capteur 1, alors que le capteur est dans un état naturellement ouvert. L'apparition d'un écart entre le premier ensemble de valeurs et le deuxième ensemble de valeurs caractérise en effet la fermeture du capteur 1.

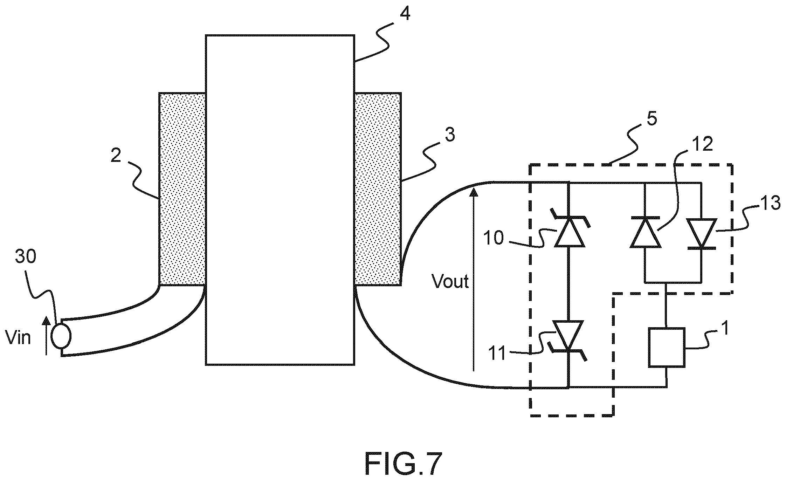

Selon un autre mode de réalisation, illustré par la figure 7, le circuit électrique non-linéaire 5 comprend une première branche et une deuxième branche connectées en parallèle, aux bornes du second transducteur électromécanique 3. La première branche comprend deux diodes Zener (10, 11) connectées en tête bêche en série, c'est-à-dire connectées par leur anode respective.

La deuxième branche comprend deux diodes (12, 13) connectées en parallèle, et polarisées en inverse l'une par rapport à l'autre. L'ensemble des deux diodes (12, 13) connectées en parallèle est connecté en série avec le capteur 1.

Ce mode de réalisation permet avantageusement, de déterminer facilement l'impédance du capteur 1, et non pas seulement son état ouvert ou fermé. Cela est particulièrement avantageux pour les capteurs à réponse linéaire, comprenant une résistance variable ou une capacité variable.

En effet, à très faible amplitude, telle que la tension Vout soit inférieure à la tension de seuil des diodes 12 et 13, les diodes 12 et 13, ainsi que les diodes Zener 10 et 11, sont bloquées, et le circuit non linéaire 5 est assimilé à un circuit ouvert. Un premier ensemble de valeurs d'un paramètre caractéristique de l'impédance vue par le premier transducteur électromécanique peut ainsi être déterminé (impédance Zin1).

Il est également possible de mesurer une impédance Zin2 pour une amplitude telle que Vout soit supérieure à la tension de seuil des diodes 12 et 13, mais inférieure à la tension Zener des diodes Zener 10 et 11 (par exemple 6 V). Cela revient ainsi à mesurer un équivalent d'un circuit non linéaire formé par les diodes 12 et 13 et par le capteur 1.

Par ailleurs, à très forte amplitude, telle que la tension Vout à vide soit supérieure à la tension Zener des diodes Zener 10 et 11 (par exemple deux fois supérieure), les diodes Zener 10 et 11 sont passantes, et le circuit non linéaire 5 est assimilé à un court-circuit. Un troisième ensemble de valeurs d'un paramètre caractéristique de l'impédance vue par le premier transducteur électromécanique peut ainsi être déterminé (impédance Zin3).

En « positionnant » l'impédance Zin2 par rapport à Zin1 (circuit-ouvert) et Zin3 (court-circuit), notamment au regard du paramètre caractéristique associé (résistance variable ou capacité variable), il est possible de trouver/positionner la valeur intermédiaire correspondant à l'impédance du capteur physique, tout en s'affranchissant des effets du canal.

Une mesure Mes de l'impédance du capteur peut par exemple être déduite par des ratios relatifs, par la formule suivante :

$$Mes = \alpha.\Delta(Zin2-Zin1)/\Delta(Zin3-Zin1)+\beta \qquad (1)$$

Où $\Delta$ représente l'écart sur le paramètre caractéristique de l'impédance, $\alpha$ et $\beta$ sont des paramètres prédéterminés propre au capteur 1. L'écart peut être mesuré selon l'un des modes de réalisation précédemment décrits.

Il est possible de faire autant de mesures d'impédance Zin à autant d'amplitudes que souhaitées, par exemple pour confirmer une mesure, mais aussi pour se positionner par rapport aux seuils du/des non linéarités:

Il est par exemple possible de partir d'une amplitude de mesure très faible et de la faire monter progressivement jusqu'à obtenir un changement d'impédance et ainsi détecter une première non-linéarité.

Dans le cadre du mode de réalisation précité pour déterminer l'impédance du capteur, il est possible de continuer cette progression pour détecter une deuxième non-linéarité, et ainsi de suite pour détecter toutes les non linéarités et ainsi savoir quelle amplitude appliquer pour faire la/les bonnes mesures différentielles pour retrouver l'information du capteur physique.

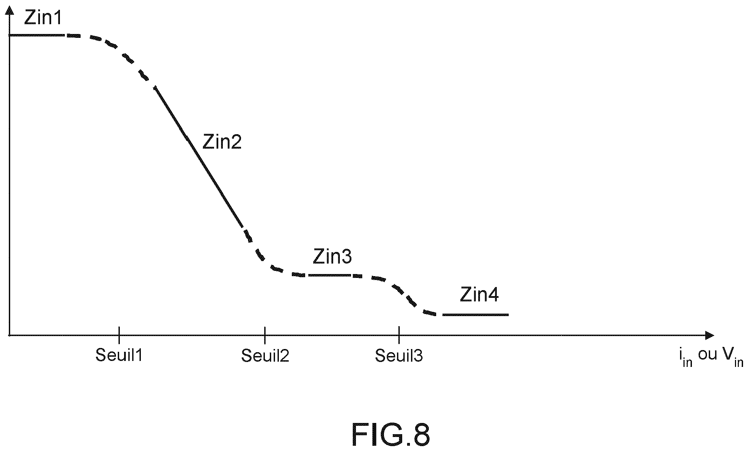

La figure 8 illustre ainsi un exemple d'évolution de l'impédance avec l'amplitude, étant entendu qu'il s'agit d'une représentation symbolique de l'impédance, qui a une composante réelle (le module) et une composante imaginaire (l'argument).

Les portions en trait plein (Zin1, Zin2, Zin3, Zin4) représentent des tendances tangentielles de l'impédance de l'ensemble constitué du capteur 1 et du circuit non linéaire 5. Quand une tendance tangentielle est inclinée, cela signifie qu'elle a une composante au moins qui dépend de l'amplitude du signal électrique aux bornes du premier transducteur 2 (intensité $i_{in}$ ou tension $V_{in}$). Lorsqu'elle est horizontale, elle est sensiblement constante dans la plage d'amplitude considérée.

Les portions en pointillés représentent les jonctions entre les tendances tangentielles de l'impédance de l'ensemble constitué du capteur 1 et du circuit non linéaire 5. Il est ainsi possible de déterminer des seuils (Seuil1, Seuil2, Seuil3) de changement d'impédance.

L'information à mesurer peut être déduite des valeurs d'impédance Zin dans les zones tangentielles ou encore de la valeur des seuils Seuil1, Seuil2 ... de changement d'impédance.

Pour s'affranchir des effets du canal, le principe consiste donc à effectuer une identification relative (Seuil2, Seuil3 par rapport à Seuil1), de façon similaire à l'équation (1).

Une mesure Mes de l'impédance du capteur peut ainsi, en variante à l'équation (1), être déduite par des ratios relatifs des seuils entre les zones tangentielles, par la formule suivante :

$$Mes = \alpha.(Seuil2-Seuil1)/(Seuil3-Seuil1)+\beta \qquad (2)$$

La détermination de l'état du capteur peut ainsi être étendue à la détermination de l'impédance du capteur, dans un mode de réalisation où le capteur n'est pas de type tout ou rien, mais un capteur linéaire, c'est-à-dire un capteur comprenant un composant électronique à valeur variable. Selon un mode de réalisation, le composant électronique à valeur variable peut être une résistance variable, une capacité variable, une inductance variable ou encore avoir une fréquence de résonance variable.

Les modes de réalisation décrits en liaison avec les figures 4, 6 et 7, dans lesquels les circuits non linéaires 5 comprennent des diodes, permettent de détecter des non linéarités liée à une amplitude en tension. L'implémentation de non linéarités liée à une amplitude en tension est relativement facile, à l'aide de composants purement passifs tels que des diodes.

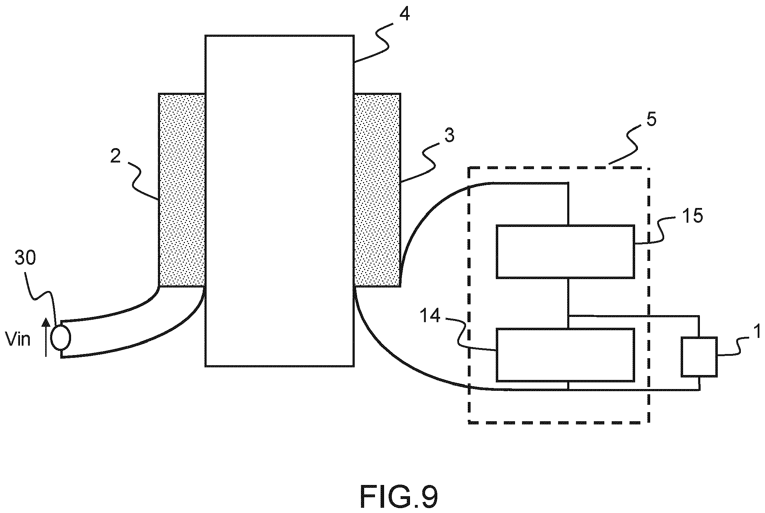

Il est également possible, selon un mode de réalisation illustré par la figure 9, de déterminer l'impédance du capteur, en détectant des non linéarités liée à une amplitude en courant.

Le circuit électrique non-linéaire 5 comprend un premier limiteur de courant 14 et un second limiteur de courant 15 connectés en série. Le premier limiteur de courant 14 peut être connecté en parallèle au capteur 1.

Chaque limiteur de courant est un régulateur de courant, à savoir un circuit agissant comme un court-circuit tant que le courant le traversant est inférieur à une valeur prédéterminée, et qui fournit un courant régulé et constant si le courant d'entrée est supérieur ou égal à la valeur prédéterminée. Chaque limiteur de courant peut être réalisé par exemple sous forme de circuit intégré, polarisé par une source de courant et utilisant des miroirs de courant.

Si le courant qui traverse le circuit non linéaire 5 est inférieur à la valeur du courant de court-circuit (courant seuil) du premier limiteur de courant 14 et du second limiteur de courant 15, les limiteurs de courant agissent en tant que court-circuit. Un premier ensemble de valeurs d'un paramètre caractéristique de l'impédance vue par le premier transducteur électromécanique peut ainsi être déterminé (impédance Zin1).

Il est également possible de mesurer une impédance Zin2 pour une amplitude telle que le courant qui traverse le circuit non linéaire 5 soit supérieur au courant de court-circuit du premier limiteur de courant 14 et inférieur au courant de court-circuit du second limiteur de courant 15. Le second limiteur de courant 15 est en court-circuit, et le premier limiteur de courant 14 est assimilé à un circuit ouvert. Le courant passe en partie par le capteur 1, ce qui permet de mesurer une impédance Zin2.

A très forte amplitude, telle que le courant qui traverse le circuit non linéaire 5 soit supérieur au seuil du premier limiteur de courant 14 et du second limiteur de courant 15, le second limiteur de courant 15 est assimilé à un circuit ouvert, ce qui permet de mesurer une impédance Zin3.

La détermination de l'impédance du capteur 1 peut ensuite être effectuée par des ratios relatifs, comme indiqué dans l'équation (1) en lien avec le mode de réalisation illustré par la figure 7.

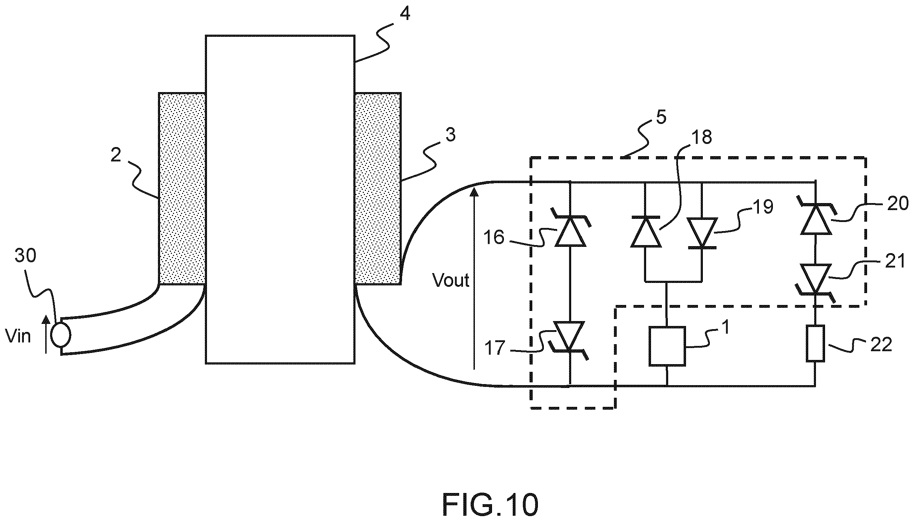

Le mode de réalisation illustré par la figure 10 permet de déterminer l'état d'un premier capteur 1 et d'un deuxième capteur 22.

Le circuit non linéaire 5 comprend une première branche, une deuxième branche et une troisième branche connectées en parallèle. La première branche comprend deux diodes Zener (16, 17) connectées en tête bêche en série, c'est-à-dire connectées entre elles par leur anode.

La deuxième branche comprend deux diodes (18, 19) connectées en parallèle et polarisées en inverse. L'anode de la première diode 18, et la cathode de la deuxième diode 19 sont connectées au premier capteur 1.

La troisième branche comprend deux diodes Zener (20, 21) montées en tête bêche en série. La cathode d'une des deux diodes Zener (20, 21) est connectée en série avec un deuxième capteur 22.

La tension Zener des diodes Zener (16, 17) de la première branche est de préférence supérieure à la tension Zener des diodes Zener (20, 21) de la troisième branche, de façon à les rendre passantes pour des amplitudes différentes.

A très faible amplitude, telle que la tension Vout aux bornes du circuit non linéaire 5 soit inférieure à une première tension de seuil Vth1 correspondant à la tension de seuil des diodes 18 et 19 disposées en série avec le premier capteur, toutes les diodes du circuit sont bloquées, le circuit non linéaire 5 forme un circuit ouvert. Une première impédance Zin1 est mesurée.

En augmentant l'amplitude de façon à ce que la tension Vout aux bornes du circuit non linéaire 5 soit comprise entre la première tension de seuil Vth1 et une deuxième tension de seuil Vth2 correspondant à la tension Zener des diodes Zener (20, 21) de la troisième branche, une impédance Zin2 est mesurée. Dans cette configuration, seules les diodes 18 et 19 sont passantes, et l'impédance Zin2 permet ainsi de calculer une impédance du premier capteur 1, selon la procédure décrite précédemment. La configuration est en effet, dans ce cas, identique à celle illustrée par la figure 7.

Il est également possible de déterminer l'état ouvert ou fermé du premier capteur 1, en fonction de l'écart mesuré entre l'ensemble de valeurs du paramètre caractéristique de la première impédance Zin1 et l'ensemble de valeurs du paramètre caractéristique de la deuxième impédance Zin2.

En augmentant encore l'amplitude du signal électrique de façon à ce que la tension Vout aux bornes du circuit non linéaire 5 soit comprise entre la deuxième tension de seuil Vth2 et une troisième tension de seuil Vth3 correspondant à la tension Zener des diodes Zener (16, 17) de la première branche, les diodes Zener (20, 21) de la troisième branche deviennent passantes.

Il est alors possible de mesurer une impédance Zin3, et, connaissant l'impédance du premier capteur 1 calculé à l'étape précédente, il est possible de déterminer l'impédance du deuxième capteur 22.

Il est également possible de déterminer l'état ouvert ou fermé du deuxième capteur 22, en fonction de l'écart mesuré entre l'ensemble de valeurs du paramètre caractéristique de la deuxième impédance Zin2 et l'ensemble de valeurs du paramètre caractéristique de la troisième impédance Zin3, en connaissant par ailleurs l'état ouvert ou fermé du premier capteur 1, déterminé précédemment.

En augmentant encore l'amplitude de façon à ce que la tension Vout à vide aux bornes du circuit non linéaire 5 soit supérieure à la troisième tension de seuil Vth3, les diodes Zener 16 et 17 deviennent passantes, ce qui crée sensiblement un court-circuit. Une impédance Zin4 est également mesurée.

On entend par « sensiblement en court-circuit », un état dans lequel la tension Vout est limitée à une amplitude significativement inférieure à la tension Vout à vide, par exemple d'un facteur au moins deux, avantageusement d'un facteur au moins trois.

La détermination de l'impédance du premier capteur 1 et du deuxième capteur 22 peut ensuite être effectuée par des ratios relatifs, comme indiqué dans l'équation (1) en liaison avec la figure 8.

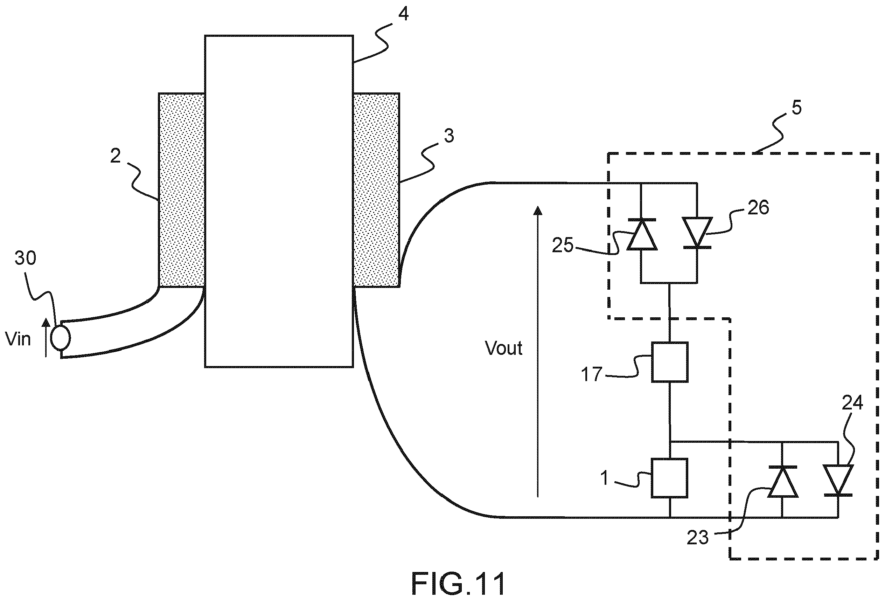

La figure 11 illustre un mode de réalisation qui permet de déterminer l'état ouvert ou fermé de deux capteurs, ou encore son impédance s'il s'agit d'un capteur à réponse linéaire, en variante du mode de réalisation illustré par la figure 10.

Le circuit électrique non-linéaire 5 comprend une première branche et une deuxième branche. La première branche comprend deux diodes connectées en parallèle (23, 24) et polarisées en inverse l'une par rapport à l'autre, et connectées en parallèle à un premier capteur 1.

La deuxième branche comprend deux diodes connectées en parallèles (25, 26) et polarisées en inverse l'une par rapport à l'autre, et connectées en série avec un deuxième capteur 22. Le premier capteur 1 et le deuxième capteur 22 sont connectés en série.

Toutes les diodes du circuit électrique non-linéaire 5 ont la même tension de seuil.

Une première impédance Zin1 vue par le premier transducteur 2 est mesurée à une amplitude telle que la tension Vout aux bornes du circuit électrique non-linéaire 5 est inférieure à une première tension de seuil Vth1 qui correspond à la tension de seuil des diodes 25 et 26 de la deuxième branche. Les diodes 25 et 26 sont bloquées, l'impédance d'un équivalent de circuit ouvert est ainsi mesurée.

Une deuxième impédance Zin2 vue par le premier transducteur 2 est mesurée à une amplitude telle que la tension Vout soit comprise entre la première tension de seuil Vth1 et une seconde tension de seuil Vth2 qui correspond à la somme de la tension seuil des diodes de la première branche et de la tension seuil des diodes de la deuxième branche. A cette amplitude, un équivalent des deux capteurs 1 et 22 mis en série peut être déterminé.

Une troisième impédance Zin3 vue par le premier transducteur 2 est mesurée à une amplitude telle que la tension Vout soit supérieure à la seconde tension de seuil Vth2. A cette amplitude, le premier capteur 1 est sensiblement court-circuité, les diodes 25 et 26 de la deuxième branche sont passantes et écrêtent l'amplitude de la tension vue par le premier capteur 1. Un équivalent du deuxième capteur 22 peut ainsi être déterminé.

L'information sur le premier capteur 1 est alors déduite de la connaissance de l'impédance liée à la somme des deux capteurs et à l'impédance liée au capteur 22 seul.

La détermination de l'impédance du premier capteur 1 et du deuxième capteur 22 peut être effectuée par des ratios relatifs, comme indiqué dans l'équation (1) en liaison avec la figure 8.

Ce mode de réalisation est particulièrement avantageux car la détermination de l'état du premier capteur 1 est possible même lorsque le second capteur 22 est accidentellement en court-circuit.

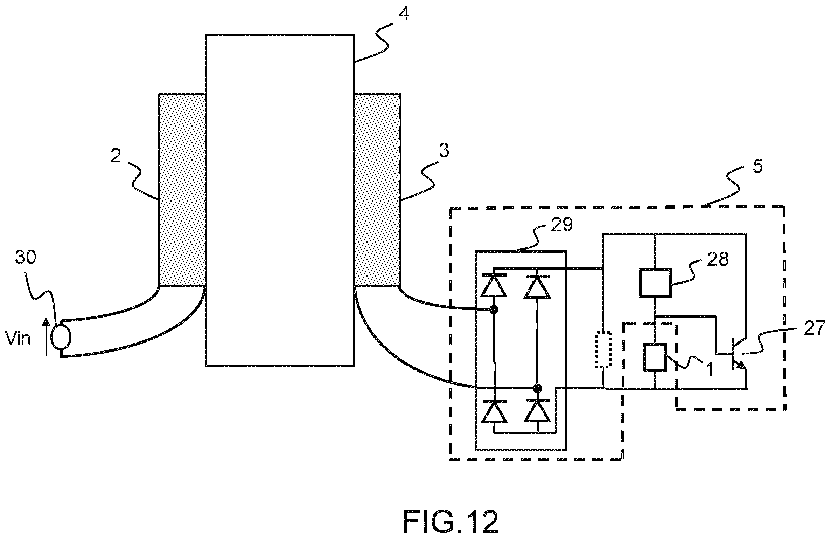

La figure 12 illustre un autre mode de réalisation du système selon l'invention. Le circuit électrique non-linéaire 5 comprend un pont redresseur 29 connecté aux bornes du second transducteur électromécanique 3, et un transistor 27 commandé par la tension aux bornes du capteur 1.

Le capteur 1 est un capteur de température lié à l'évolution de la tension de seuil du transistor 27 avec la température. La tension de seuil correspond à la tension de grille qui fait la transition entre le comportement bloqué du transistor et son comportement conducteur. Selon une variante, le capteur 1 peut être un capteur résistif.

Le transistor 27 peut être un transistor bipolaire. La base du transistor 27 est connectée au capteur 1 et à une résistance 28. Le collecteur du transistor 27 est connecté à la résistance 28 et au pont redresseur 29. L'émetteur du transistor 27 est connecté au capteur 1 et au pont redresseur 29. Le schéma de la figure 12 correspond à un montage avec un transistor 27 de type NPN. L'homme du métier pourrait adapter ce montage à un transistor 27 de type PNP. Le mode de réalisation n'est toutefois pas limité aux transistors bipolaires.

Une première amplitude peut être identifiée de façon à ce que les diodes du pont redresseur 29 soient mises en conduction, ce qui correspond à deux seuils de diode.

La deuxième amplitude dépend de la tension de mise en conduction du transistor. Cette tension de mise en conduction dépend par exemple de la température de jonction du transistor (capteur de température) ou de la valeur de la résistance variable (capteur résistif). Par exemple, la résistance variable du capteur 1 influe sur la tension de seuil du transistor 27. L'information relative à l'état du capteur est donc liée à la valeur du seuil.

Via une amplitude croissante, on détecte ainsi un premier changement d'impédance lorsque les diodes du pont redresseur 29 deviennent passantes, puis un deuxième changement d'impédance quand le transistor 27 devient passant. En mesurant l'écart entre le deuxième seuil et le premier seuil, on en déduit la valeur du premier capteur 1 ou de la température.

**Revendications**

**1.** Procédé de détermination de l'état d'au moins un capteur (1), ledit procédé utilisant un premier transducteur élec-

troméccanique (2) et un second transducteur électroméccanique (3) méccaniquement couplés à un support (4), et un circuit électrique non-linéaire exclusivement analogique (5) électriquement connecté entre le second transducteur électroméccanique (3) et le capteur (1), le procédé comprenant les étapes consistant à :

- appliquer un signal électrique (Vin) à une première amplitude aux bornes du premier transducteur électroméccanique (2), et déterminer un premier ensemble de valeurs (Mod1, Arg1) d'un paramètre caractéristique de l'impédance électrique du premier transducteur électroméccanique (2) en réponse à l'application dudit signal électrique (Vin) (100) ;
- appliquer ledit signal électrique à une deuxième amplitude aux bornes du premier transducteur électroméccanique (2), et déterminer un deuxième ensemble de valeurs (Mod2, Arg2) du paramètre caractéristique de l'impédance (200) ;
- mesurer un écart entre le premier ensemble de valeurs (Mod1, Arg1) et le deuxième ensemble de valeurs (Mod2, Arg2) (300) ;
- déterminer un état du capteur (1) en fonction de l'écart entre le premier ensemble de valeurs (Mod1, Arg1) et le deuxième ensemble de valeurs (Mod2, Arg2) (400).

2. Procédé selon la revendication 1, dans lequel le capteur (1) comprend un composant électronique à valeur variable, le procédé comprenant les étapes consistant à :

- déterminer une première valeur (Mod1, Arg1) d'un paramètre caractéristique de l'impédance électrique du premier transducteur électromécanique (2), à la première amplitude,
- déterminer une deuxième valeur (Mod2, Arg2) d'un paramètre caractéristique de l'impédance électrique du premier transducteur électromécanique (2), à la deuxième amplitude, la première valeur et la deuxième valeur étant telles que l'écart soit non nul,
- appliquer le signal électrique à une troisième amplitude, la troisième amplitude étant comprise entre la première amplitude et la deuxième amplitude, et déterminer une troisième valeur (Mod1, Arg1) d'un paramètre caractéristique de l'impédance électrique du premier transducteur électromécanique (2), à la troisième amplitude,
- déterminer la valeur variable du composant électronique à valeur variable en fonction de la première valeur, de la deuxième valeur, et de la troisième valeur.

3. Procédé selon l'une des revendications précédentes, dans lequel la mesure d'un écart entre le premier ensemble de valeurs et le deuxième ensemble de valeurs est effectuée dans une plage de fréquences prédéfinie, et comprend, à l'intérieur de la plage de fréquences, une mesure d'un écart de fréquences entre les passages par une valeur de module d'impédance prédéfinie ou par une valeur d'argument d'impédance prédéfini du premier ensemble de valeurs et du deuxième ensemble de valeurs.

4. Procédé selon l'une des revendications 1 ou 2, dans lequel la mesure d'un écart entre le premier ensemble de valeurs et le deuxième ensemble de valeurs est effectuée dans une plage de fréquences prédéfinie, et comprend, à l'intérieur de la plage de fréquences, une mesure d'un écart de fréquences entre la valeur extrêmale du premier ensemble de valeurs et la valeur extrêmale du deuxième ensemble de valeurs.

5. Procédé selon l'une des revendications 1 ou 2, dans lequel la mesure d'un écart entre le premier ensemble de valeurs et le deuxième ensemble de valeurs est effectuée dans une plage de fréquences prédéfinie, et comprend, à l'intérieur de la plage de fréquences, une mesure de l'écart de phase entre le premier ensemble de valeurs et le deuxième ensemble de valeurs à des fréquences correspondant à une valeur prédéfinie ou un extremum du module du premier ensemble de valeurs et à une valeur prédéfinie ou un extremum du module du deuxième ensemble de valeurs.

6. Procédé selon l'une des revendications 1 ou 2, dans lequel la mesure d'un écart entre le premier ensemble de valeurs et le deuxième ensemble de valeurs est effectuée dans une plage de fréquence prédéfinie, et comprend, à l'intérieur de la plage de fréquences, une mesure de l'écart de module entre le premier ensemble de valeurs et le deuxième ensemble de valeurs à des fréquences correspondant à une valeur prédéfinie ou un extremum de phase du premier ensemble de valeurs et à une valeur prédéfinie ou un extremum de phase du deuxième ensemble de valeurs.

7. Système de détermination de l'état d'au moins un capteur (1), le système comprenant un premier transducteur électroméccanique (2) et un second transducteur électroméccanique (3) méccaniquement couplés à un support (4), et un circuit électrique non-linéaire exclusivement analogique (5) électriquement connecté entre le second transducteur électromécanique (3) et le capteur (1), le système comprenant une unité (30) de détermination d'état de capteur, l'unité (30) de détermination d'état de capteur étant configurée pour :

- appliquer un signal électrique (Vin) à une première amplitude aux bornes du premier transducteur électromécanique (2), et déterminer un premier ensemble de valeurs (Mod1, Arg1) d'un paramètre caractéristique de l'impédance électrique du premier transducteur électromécanique (2) en réponse à l'application dudit signal électrique (Vin) (100) ;
- appliquer ledit signal électrique à une deuxième amplitude aux bornes du premier transducteur électromécanique (2), et déterminer un deuxième ensemble de valeurs (Mod2, Arg2) du paramètre caractéristique de l'impédance (200) ;
- mesurer un écart entre le premier ensemble de valeurs (Mod1, Arg1) et le deuxième ensemble de valeurs (Mod2, Arg2) (300) ;
- déterminer un état du capteur (1) en fonction de l'écart entre le premier ensemble de valeurs (Mod1, Arg1) et le deuxième ensemble de valeurs (Mod2, Arg2) (400).

8.  Système selon la revendication 7, dans lequel le circuit électrique non-linéaire (5) comprend deux diodes en parallèle (6, 7) et polarisées en inverse l'une par rapport à l'autre, les diodes (6, 7) étant configurées pour être connectées en parallèle avec le capteur (1).

9.  Système selon la revendication 7, dans lequel le circuit électrique non-linéaire (5) comprend deux diodes Zener (8, 9) montées en tête bêche en série, les diodes Zener (8, 9) étant configurées pour être connectées en série avec le capteur (1).

10. Système selon la revendication 7, dans lequel le circuit électrique non-linéaire (5) comprend une première branche et une deuxième branche connectées en parallèle, la première branche comprenant deux diodes Zener (10, 11) connectées en tête bêche en série, la deuxième branche comprenant deux diodes (12, 13) connectées en parallèle, polarisées en inverse l'une par rapport à l'autre, et configurées pour être connectées en série avec le capteur (1).

11. Système selon la revendication 7, dans lequel le circuit électrique non-linéaire (5) comprend un premier limiteur de courant (14) et un second limiteur de courant (15) connectés en série, le premier limiteur de courant (14) étant par ailleurs configuré pour être connecté en parallèle au capteur (1), la valeur du courant de court-circuit du premier limiteur de courant (14) étant inférieure à la valeur du courant de court-circuit du second limiteur de courant (15).

12. Système selon la revendication 7, dans lequel le circuit électrique non-linéaire comprend une première branche, une deuxième branche et une troisième branche connectées en parallèle, la première branche comprenant deux diodes Zener (16, 17) connectées en tête bêche en série, la deuxième branche comprenant deux diodes (18, 19) connectées en parallèle et polarisées en inverse l'une par rapport à l'autre, et configurées pour être connectées en série avec un premier capteur (1), la troisième branche comprenant deux diodes Zener (20, 21) montées en tête bêche en série, les diodes Zener (20, 21) de la troisième branche étant configurées pour être connectées en série avec un deuxième capteur (22).

13. Système selon la revendication 7, dans lequel le circuit électrique non-linéaire (5) comprend une première branche et une deuxième branche, la première branche comprenant deux diodes connectées en parallèle (23, 24) et polarisées en inverse l'une par apport à l'autre, et configurées pour être connectées en parallèle à un premier capteur (1), la deuxième branche comprenant deux diodes connectées en parallèles (25, 26) et polarisées en inverse l'une par apport à l'autre, la première et la deuxième branche étant configurées pour être connectées en série à un deuxième capteur (22).

14. Système selon la revendication 7, dans lequel le circuit électrique non-linéaire (5) comprend un pont redresseur (29) connecté aux bornes du second transducteur électromécanique (3), et un transistor (27) commandé par la tension aux bornes du capteur (1), l'unité de détermination d'état de capteur étant configurée pour déterminer un état du capteur (1) en fonction de la tension de mise en conduction du transistor (27).

15. Système selon l'une des revendications 7 à 14, dans lequel le premier transducteur électromécanique (2) et le second transducteur électromécanique (3) comprennent chacun un composant piézoélectrique.

FIG.1

FIG.2

FIG.3

FIG.4

FIG.5

FIG.6

FIG.7

EP 4 198 507 A1

Zin1

Zin2

Zin3

Zin4

Seuil1    Seuil2    Seuil3    $i_{in}$ ou $V_{in}$

FIG.8

FIG.9

FIG.10

FIG.11

EP 4 198 507 A1

FIG.12

**Europäisches Patentamt**
**European Patent Office**
**Office européen des brevets**

# RAPPORT DE RECHERCHE EUROPEENNE

Numéro de la demande

EP 22 21 3369

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2021/197735 A1 (TDK ELECTRONICS AG [DE]) 7 octobre 2021 (2021-10-07) * le document en entier * | 1-15 | INV. G01N29/12 G01N29/48 G01N29/50 H04B5/00 |
| A | DING-XIN YANG ET AL: "Through-Metal-Wall Power Delivery and Data Transmission for Enclosed Sensors: A Review", SENSORS, vol. 15, no. 12, 15 décembre 2015 (2015-12-15), pages 31581-31605, XP055755285, DOI: 10.3390/s151229870 * le document en entier * | 1-15 | |
| A,D | US 5 594 705 A (CONNOR DENIS J [CA] ET AL) 14 janvier 1997 (1997-01-14) * le document en entier * | 1-15 | |

**DOMAINES TECHNIQUES RECHERCHES (IPC)**

G01N
H04B

Le présent rapport a été établi pour toutes les revendications

| Lieu de la recherche | Date d'achèvement de la recherche | Examinateur |
|---|---|---|
| Munich | 4 mai 2023 | Roetsch, Patrice |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.............................................................................
& : membre de la même famille, document correspondant

EPO FORM 1503 03.82 (P04C02)

**EP 4 198 507 A1**

## ANNEXE AU RAPPORT DE RECHERCHE EUROPEENNE
## RELATIF A LA DEMANDE DE BREVET EUROPEEN NO.

EP 22 21 3369

04-05-2023

| Document brevet cité au rapport de recherche | | Date de publication | Membre(s) de la famille de brevet(s) | | Date de publication |
|---|---|---|---|---|---|
| WO 2021197735 | A1 | 07-10-2021 | AT | 17666 U2 | 15-10-2022 |
| | | | CN | 114258566 A | 29-03-2022 |
| | | | DE | 112021002067 A5 | 12-01-2023 |
| | | | US | 2022321237 A1 | 06-10-2022 |
| | | | WO | 2021197735 A1 | 07-10-2021 |
| US 5594705 | A | 14-01-1997 | AUCUN | | |

EPO FORM P0460

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5594705 A